# EUROPEAN PATENT SPECIFICATION

(11) **EP 2 630 078 B1**
(45) Date of publication and mention of the grant of the patent: **19.08.2015**
(21) Application number: 11834880.4
(22) Date of filing: 13.10.2011
(51) Int. Cl.: B82B 3/00, B82B 1/00, B82Y 40/00

(54) **NANO-SCALE STRUCTURES**
NANOSKALIGE STRUKTUREN
STRUCTURES NANOMÉTRIQUES

(30) Priority: 21.10.2010 WO PCT/US2010/053533
(43) Date of publication of application: 28.08.2013
(73) Proprietor: Hewlett-Packard Development Company, L.P., Houston, TX 77070 (US)
(72) Inventor: MARDILOVICH, Peter, Corvallis Oregon 97330 (US); WEI, Qingqiao, Corvallis Oregon 97330 (US); FULLER, Anthony M., Corvallis Oregon 97330 (US)
(74) Representative: Lawman, Matthew John Mitchell
(86) International application number: PCT/US2011/056067
(87) International publication number: WO 2012/054286

(56) References cited:
- US-A1- 2008 093 698
- US-A1- 2008 093 698
- NIELSCH K ET AL: "UNIFORM NICKEL DEPOSITION INTO ORDERED ALUMINA PORES BY PULSED ELECTRODEPOSITION", ADVANCED MATERIALS, WILEY - V C H VERLAG GMBH & CO. KGAA, DE, vol. 12, no. 8, 18 April 2000 (2000-04-18) , pages 582-586, XP000932909, ISSN: 0935-9648, DOI: 10.1002/(SICI)1521-4095(200004)12:8<582::A ID-ADMA582>3.3.CO;2-V
- MOZALEV A ET AL: "Nucleation and growth of the nanostructured anodic oxides on tantalum and niobium under the porous alumina film", ELECTROCHIMICA ACTA, ELSEVIER SCIENCE PUBLISHERS, BARKING, GB, vol. 48, no. 20-22, 30 September 2003 (2003-09-30), pages 3155-3170, XP004447013, ISSN: 0013-4686, DOI: 10.1016/S0013-4686(03)00345-1
- Jihun Oh: "Porous Anodic Aluminum Oxide Scaffolds; Formation Mechanisms and Applications", , 1 February 2000 (2000-02-01), XP055117405, DSpace@MIT Retrieved from the Internet: URL:http://dspace.mit.edu/bitstream/handle /1721.1/59709/668428538.pdf?sequence=1 [retrieved on 2014-05-12]
- NIELSCH K. ET AL.: 'Uniform nickel deposition into ordered alumina pores by pulsed electrodeposition.' ADVANCED MATERIALS vol. 12, no. 8, 2000, pages 582 - 586, XP002548117
- MOZALEV A. ET AL.: 'Nucleation and growth of the nanostructured anodic oxides on tantalum and niobium under the porous alumina film.' ELECTROCHIMICA ACTA vol. 48, 2003, pages 3155 - 3170, XP004447013
- TEH L.K. ET AL.: 'Electrodeposition of CdSe on nanopatterned pillar arrays for photonic and photovoltaic applications.' THIN SOLID FILMS vol. 515, 2007, pages 5787 - 5791, XP022212764
- HUANG Z. ET AL.: 'Improved SERS performance from Au nanopillar arrays by abridging the pillar tip spacing by Ag sputtering.' ADVANCED MATERIALS vol. 22, 01 October 2010, pages 4136 - 4139, XP055088418

## Description

### BACKGROUND

Nano-structures are suitable for use in a wide variety of applications, including applications for shock absorption, promoting adhesion, tuning surface wettability, and micro- or nano-fluidic filtration, among other applications. Nano-scale structures may be formed on a surface using a template formed on a surface, and then filling pores in the template with a select material. Once the pores are sufficiently filled, the template may be removed to expose nano-structures on and above the surface.
"Uniform Nickel Deposition into Ordered Alumina Pored by Pulsed Electrodeposition" by Nielsch et al discloses a process for fabricating nanoscale structures in which an alumina pore structure is formed by anodization, nickel is deposited into the pores by electrodeposition, and in which monodisperse nanowires are formed by dissolving the porous alumina following electrodeposition.
US 2008/093698 discloses a method of forming an array of elongated nanostructures.
"Nucleation and growth of the nanostructured anodic oxides on tantalum and niobium under the porous alumina film" by Mozalev et al discloses anodic oxidation of aluminium deposited on tantalum and aluminium deposited on niobium to form nanoscale oxide "hillocks" and "goblets".
"Porous Anodic Aluminium Oxide Scaffolds; Formation Mechanisms and Applications" by Jihun Oh discloses methods of creating nanostructured porous anodic aluminium oxide.

### BRIEF DESCRIPTION OF THE DRAWINGS

Features and advantages of embodiments of the present disclosure will become apparent with reference to the following detailed description and drawings, in which like reference numerals correspond to similar, though perhaps not identical, components. For the sake of brevity, reference numerals or features having a previously described function may or may not be described in connection with other drawings in which they appear.
Fig. 1 is a simplified perspective view of an example article including nano-structures extending from a base layer formed in accordance with an embodiment of the present invention.
Fig. 2 is a somewhat schematic cross-sectional view of the example article shown in Fig. 1, taken generally along line 2-2 of Fig. 1.
Figs. 3A through 3E schematically depict a method of forming a nano-structure array and base layer in accordance .with an embodiment of the present invention.
Fig. 4 is a flowchart showing a method of forming a nano-structure array and base layer in accordance with an embodiment of the present invention.
Fig. 5 is a flowchart showing a method of forming a nano-structure array and base layer in accordance with another embodiment of the present invention.

### DETAILED DESCRIPTION

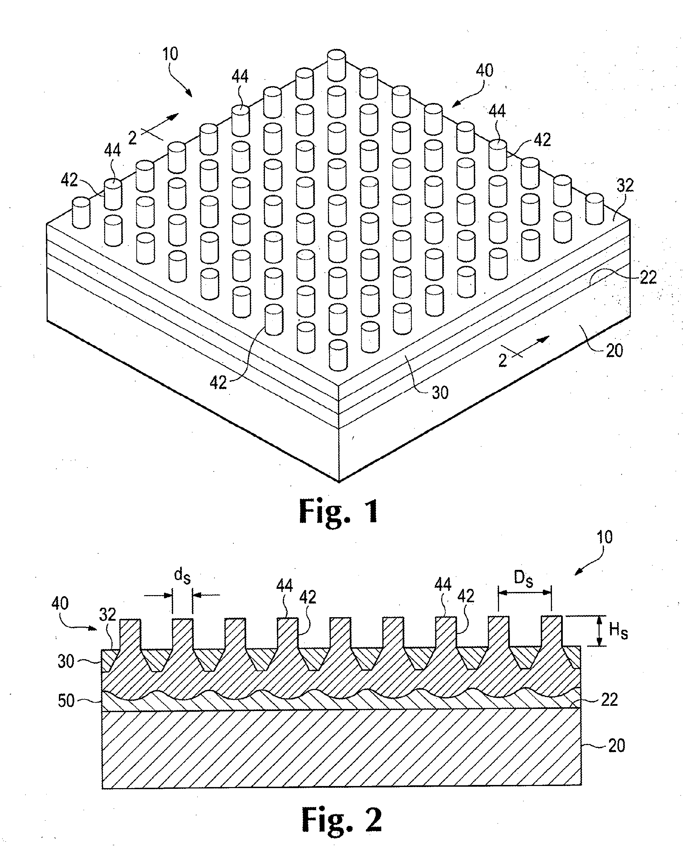

Referring initially to Fig. 1, an article 10 is shown, the depicted article including a substrate 20 having a base layer 30 and a nano-structure array 40 extending therefrom. As will be described further below, the nano-structure array may include nano-structures 42 formed on a substrate surface 22. The base layer, in turn, may be formed by applying a base material between the nano-structures. The base material may be virtually any material, but in the present examples, is selected from materials suitable for electrochemical deposition in order to achieve nano-scale structures, as described below

Base layer 30 may define a substantially planar base surface 32, from which nano-structures 42 extend. Accordingly, where the nano-structures are of substantially uniform height, as in the present examples, the nano-structures will be seen to terminate in distal ends 44 that are substantially uniformly spaced from base surface 32. The nano-structures also may be of substantially uniformly size and shape, and may be substantially uniformly distributed across base layer 32.

The methods disclosed herein may be used to control various properties of the nano-structures. For example, placement of nano-structures in the nano-structure array may be selectively controlled. Similarly, the size of gap formed between adjacent nano-structures may be controlled, and the geometry and/or dimensions of the nano-structures (such as their height, diameter, shape, etc.) may be controlled.

In one example, nano-structures 42 are elongate structures that extend orthogonal to a plane defined by substrate surface 22. As shown in Fig. 2, nano-structures 42 are generally columnar, each characterized as having a diameter (d_{S}) (also referred to herein as thickness) and a height (H_{S}) above base layer 30. The geometry of the nano-structures may be controlled so that the nano-structures each have a substantially cylindrical shape. The nano-structures also may have substantially uniform height (H_{S}), and the substantially uniform pitch (D_{S}) (the center-to-center distance between nano-structures). Dimensions of nano-structures generally will vary by less than 10% to 20% (for nanometer scale dimensions), and in some examples, may vary by as little as 1% or 2%.

Although columnar nano-structures are shown for illustrative purposes, the nano-structures can have other geometries, which may be determined at least in part by parameters of the fabrication process described below. For example, height, diameter, shape, and spacing between nano-structures may be controlled. It thus will be appreciated that the fabrication process may be manipulated to tune nano-structure geometry and spacing to accommodate a variety of purposes.

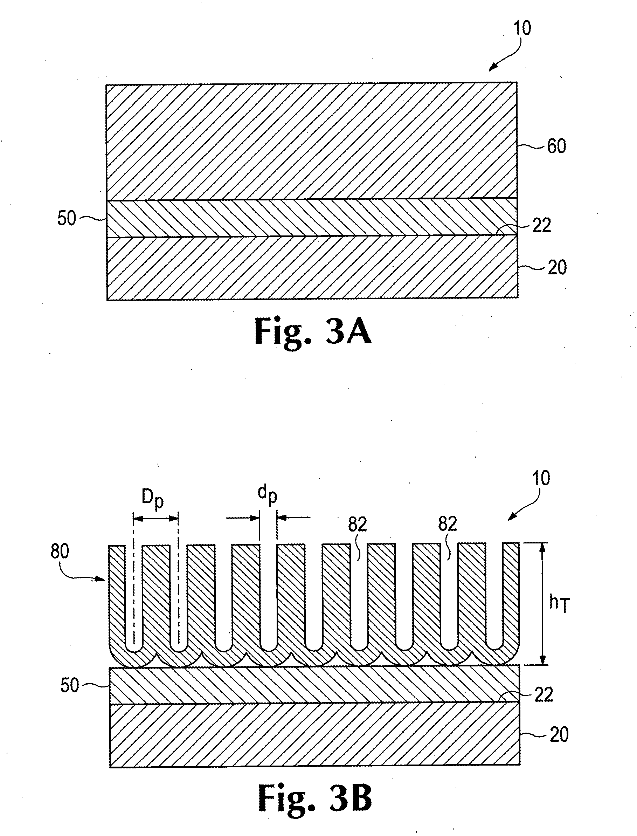

Figs. 3A-3E depict an article 10 throughout fabrication of a nano-structured substrate as described herein. As shown, a substrate 20 thus may be adapted, through the present method, to define an integral nano-structured surface 22. Although a particular nano-structure geometry is shown, it will be understood that the fabrication process parameters may be altered to achieve different geometries.

Referring initially to Fig. 3A, fabrication begins with a substrate 20. Substrate 20 may be selected based, at least in part, on the whether or not the material will provide a suitably planar surface 22 and/or based on the intended use of the article to be produced. In some examples, substrate 20 may be a substantially planar silicon wafer. Substrate 20, however, similarly may be formed from other materials, e.g., glass, quartz, alumina, stainless steel, plastic, and/or the like, and may take any of a variety of forms, including a multilayer structure.

As shown, a first oxidizable material (also referred to as an oxidizable nano-structure material) is deposited on a surface 22 of substrate 20 to form a layer of first oxidizable material 50. The first oxidizable material layer 50 may be formed using any suitable deposition technique known in the art. Some non-limiting examples of suitable deposition techniques include physical vapor deposition (PVD) (such as sputtering, thermal evaporation and pulsed laser deposition), atomic layer deposition (ALD), or, in some instances, chemical vapor deposition (CVD).

In some examples, the first oxidizable material layer 50 may be formed of a metal or metal alloy that forms a dense metal oxide after electrochemical oxidation. Suitable oxidizable materials include oxidizable refractory metals such as tantalum (Ta), niobium (Nb), titanium (Ti), tungsten (W), or their alloys. Such oxidizable materials can be electrochemically and/or thermally oxidized, and have expansion coefficients (the ratio between thickness of the grown oxide and thickness of the consumed material) that are greater than 1.

In the present example, first oxidizable material layer 50 is formed of tantalum (Ta), which has been found suitable for use in the method described herein. The example first oxidizable material layer thus also may be referred to herein as the "Ta layer". The Ta layer may have any suitable thickness that will produce (during electrochemical oxidation) enough oxide to form the desired nano-structures (which will be described in further detail below). In some examples, the thickness of the Ta layer may be approximately 100 to 1000 nanometers.

Referring still to Fig. 3A, it will be noted that a second oxidizable material (also referred to as an oxidizable template material) is deposited on the Ta layer to form a layer of second oxidizable material 60. The second oxidizable material layer may be a material selected to produce a porous oxide (as described below), with pours that correspond to the nano-structures to be formed. The second oxidizable material may be aluminum (Al), or may be an aluminum alloy such as an alloy having aluminum as the main component. Second oxidizable material layer 60 also may be referred to herein as the "Al layer". The Al layer may have any suitable thickness that will produce (by electrochemical oxidation) enough oxide to form a template sufficient to define nano-structures , as will be described below. In some examples, the thickness of the Al layer may be approximately 100 to 1000 nanometers.

Deposition of the Al layer on the Ta layer may be accomplished using any suitable deposition technique known in the art. Some non-limiting examples of suitable deposition techniques include physical vapor deposition (PVD) (such as sputtering, thermal evaporation and pulsed laser deposition).

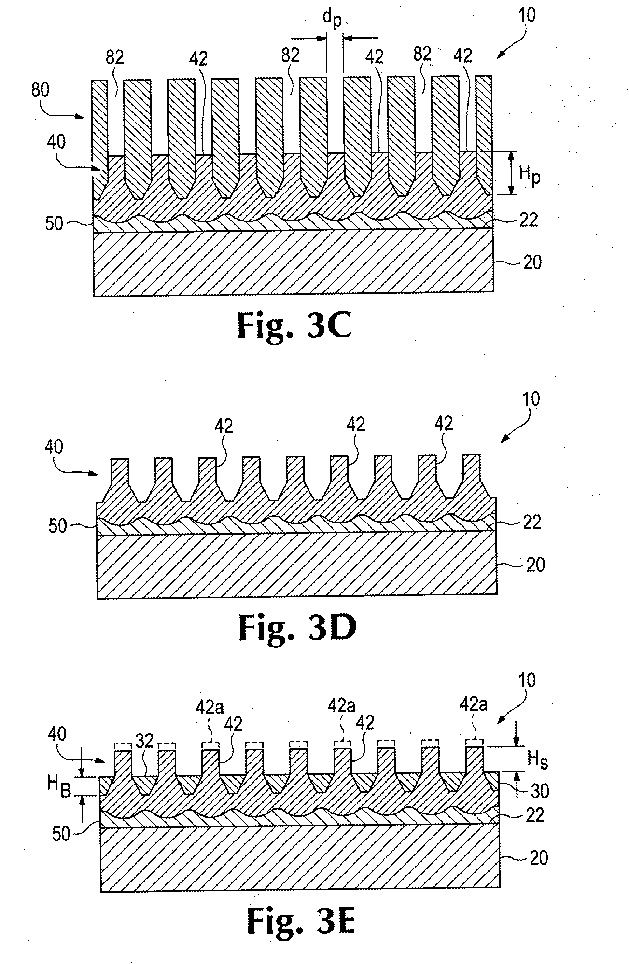

As shown generally in Fig. 3B, the multi-layer structure of Fig. 3A may be further processed to form a nano-structure template 80 on substrate 20. The nano-structure template defines a plurality of nano-pores 82, each having a first width (indicated as nano-pore diameter (dₚ), in the present example). Such nano-pores are suitable for use in forming nano-structures 42 (Fig. 3C) on the substrate surface, as will be described further below.

In some examples, further processing includes a first anodization process whereby Al layer 60 (Fig. 3A) is anodized to define a plurality of substantially uniform, cylindrical nano-pores 82. Such nano-pores may be formed by completely anodizing the Al layer (as shown in Fig. 3B) so as to produce a nano-structure template 80 in the form of a layer of porous oxide (e.g., anodic porous alumina, Al₂O₃) with nano-pores 82. Complete anodization refers to the oxidation of substantially the entire Al layer-so as to allow anodization of underlying first oxidizable material layer 50, as will be described below.

Anodization (i.e., electrochemical oxidation) is a process of forming an oxide layer on a material by making the material the anode in an electrolytic cell and passing an electric current through the cell. For anodization of aluminum, as in the present example, applied voltage may be kept constant at a voltage within a range of about 10 V to 200 V. In some examples, the first anodization process may occur at a voltage of about 30 V.

As indicated generally above, it is possible to adjust geometry by adjusting parameters of the fabrication process. For example, geometry of the nano-structure template 80 may be adjusted by varying one or more of anodization voltage, current density and electrolyte. Such adjustments to the first anodization process may alter nano-pore pitch (Dₚ) and/or nano-pore diameter (dₚ), which characteristics are illustrated in Fig. 3B. For example, nano-pore pitch may be related to anodization voltage, where nano-pore pitch (Dₚ) is 2.8 nanometers per volt of anodization voltage. Nano-pore pitch (Dₚ) generally may be adjusted within a range of from about 30 nanometers to about 500 nanometers. Nano-pore diameter (dₚ) generally may be adjusted within a range of from about 10 nanometers to about 350 nanometers.

Anodization can be performed at constant current (galvanostatic regime), at constant voltage (potentiostatic regime) or at some combination of these regimes. Nano-pore diameter (dp) is proportional to anodization voltage. Accordingly, a potentiostatic regime may be employed to produce a porous substrate with nano-pores having substantially uniform nano-pore diameter (dₚ). Substantially uniform nano-pores 82, in turn, will yield substantially uniform nano-pillars 40, as will be described below.

The first anodization process may be carried out by exposing Al layer 60 to an electrolytic bath containing an oxidizing acid such as sulfuric acid (H₂SO₄), phosphoric acid (H₃PO₄) oxalic acid (C₂H₂O₄) and/or chromic acid (H₂CrO₄). The electrolyte may be present, for example, in a water-based solution. The voltage applied during the first anodization process may be selected based on the electrolyte composition. For example, the voltage may range from 5-25V for an electrolyte based on sulfuric acid, 10-80V for an electrolyte based on oxalic acid, and 50-150V for an electrolyte based on phosphoric acid. The particular voltage used will depend on the desired pore diameter (and the suitability of such voltage for the electrolyte).

Nano-pore diameter (dₚ) also is related to the nature of the electrolyte used. Accordingly, an electrolyte may be selected to achieve a particular desired nano-pore diameter (dₚ). As non-limiting examples, nano-pores 82 of the following sizes may be obtained using the following electrolytes: nano-pore diameters (dₚ) of about 20 nanometers may be obtained using H₂SO₄ (in a water-based solution) as the electrolyte; nano-pores diameters (dₚ) of about 40 nanometers may be obtained using C₂H₂O₄ (in a water-based solution) as the electrolyte; and nano-pores diameters (dₚ) of about 120 nanometers may be obtained using H₃PO₄ (in a water-based solution) as the electrolyte.

In one example, nano-structure template 80 is formed by anodization of the Al layer 60 in a 4% solution of oxalic acid (C₂H₂O₄), at a voltage of 30 Volts until substantially the entire Al layer is consumed. For a suitably thick Al layer, the resulting nano-structure template 80 will define nano-pores 82 that are approximately 30 nanometers wide, and that will allow oxidation of underlying first oxidizable material layer 50. The nano-structure template should have a template height (h_{T}) sufficient to allow complete growth of a nano-structures 42 (Fig. 3C) within the nano-pores.

After the first anodization process, the nano-pore diameter (dₚ) may be further tuned to a target nano-pore diameter by anisotropic etching, or other suitable process (not shown). Anisotropic etching may be performed using diluted phosphoric acid (5 vol.%). The time for etching may vary, depending, at least in part, upon the desirable average diameter for the final pores. The temperature for etching may also depend upon the process, the etching rate, and the etchant used.

In some examples (not shown), prior to performing the first anodization process, the first oxidizable material layer may be patterned to precisely define locations of nano-pores 82 in the resulting nano-structure template 80. Patterning may be accomplished via any suitable technique. The patterned layer may then be anodized, for example, by employing the patterned layer as the anode of an electrolytic cell. A suitable amount of voltage and current is then applied to the electrolytic cell for an amount of time to completely anodize the patterned layer in accordance with the first anodization process described above. This can result in substantially uniformly spaced nano-structures where the variance in spacing between nano-structures differs by less than 1 % (for nanometer scale dimensions).

Referring now to Fig. 3C, nano-pores 82 may be at least partially filled to define nano-structures 42. Nano-structures 42 extend into the nano-pores to a height (H_{P}). As shown, height (H_{P}) may be substantially uniform across the substrate 20.

Nano-structures 42 may be formed via a second anodization process selected to anodize the underlying Ta layer 50. Such second anodization process will grow an oxide from the first oxidizable material (e.g., Ta), with oxide forming in the nano-pores 82 of the nano-structure template 80 from the bottom up. The resulting oxide may take the form of a dense oxide such as anodic tantalum pentoxide (Ta₂O₅).

The second anodization process may be accomplished, for example, using a process similar to the first anodization process described above. More specifically, the Ta layer 50 may be anodized by employing the Ta layer as the anode of an electrolytic cell to achieve a desired oxidation of the first oxidizable material.

For oxidation of tantalum (Ta), non-limiting examples of electrolyte may include solutions containing citric acid (C₆H₈O₇), oxalic acid (C₂H₂O₄), boric acid (H₃BO₃) ammonium pentaborate ((NH₄)₂B₁₀O₁₆ x 8H₂O), and/or ammonium tartrate (H₄NO₂CCH(OH)CH(OH)CO₂NH₄). It is to be understood that this type of anodization forms a dense oxide.

During anodization of the Ta layer 50, the formed oxide (in this example, tantalum pentoxide (Ta₂O₅)) grows through the individual nano-pores 82 defined in nano-pillar template 80 to form a nano-structure 42 in each nano-pore. The orientation of nano-structures 42 are generally controlled by the orientation of the nano-pores 82. In the present example, the nano-structures 42 are substantially orthogonal to substrate 20.

The expansion coefficient of a material to be oxidized is defined as the ratio of oxide volume to consumed material volume. The expansion coefficient for oxidation of tantalum (Ta) is approximately 2.3. Accordingly, in the present example, due to the significant expansion of tantalum pentoxide (Ta₂O₅), and the fact that the resulting oxide (Ta₂O₅) is dense, the nano-pores 82 are filled from the bottom up. It will be understood that although the first oxidizable material is tantalum (Ta) in the present example, other materials with an expansion coefficient greater than 1 would similarly allow the oxidizable material to squeeze into the nano-pores 82 of nano-structure template 80.

As indicated, the grown oxide will at least partially fill nano-pores 82 of nano-structure template 80 to define nano-structures 42. The geometries of the nano-pillars 42 generally will conform to the geometries of corresponding nano-pores 82, within which the nano-pillars are growing. Nano-pillars 42 thus may take the form of columns, substantially uniformly distributed across substrate 20.

In the present example, each nano-structure has a nominal thickness that corresponds to the nano-pore diameter (dₚ). Nano-structures 42 are grown to a preliminary nano-structure height (H_{P}). Preliminary nano-structure height (H_{P}) will be less than template height (h_{T}) (Fig. 3B).

The geometry and/or dimensions of the nano-structures 42 may further be controlled by adjusting one or more parameters of the anodization process. For example, the preliminary nano-structure height (H_{P}) will depend on the anodization voltage applied to the first oxidizable material layer 50 during its anodization. In some examples, nano-structures are formed by anodizing the first oxidizable material at a first voltage corresponding to a target preliminary nano-structure height (H_{P}) that may be selected to achieve a desired final nano-structure height (H_{S}), as will be described below.

In one example, nano-structures having a preliminary nano-structure height (H_{P}) of 90 nanometers (at a diameter (dₚ) of approximately 30 nanometers) may be formed by anodization of Ta layer 50 in a 0.1% solution of citric acid (C₆H₈O₇), at a current density of 2 mA/cm² until voltage reaches 55 Volts, and for 5 minutes more at 55V. It will be appreciated that preliminary nano-structure height (H_{P}) may be tuned to a target preliminary nano-structure height by selecting a corresponding anodization voltage.

As indicated in Fig. 3D, once nano-structures 42 are grown to the target preliminary nano-structure height (H_{P}), the nano-structure template 80 may be removed to expose the fully formed nano-structures, which define nano-structure array 40. The nano-structure template 80 may be removed using a second selective etching process that will remove the nano-structure template 80 without deleteriously affecting the nano-structures 42, or other features of article 10. In one example, the selective etching may be performed using a selective etchant containing H₃PO₄ (92g), CrO₃ (32g) and H₂O (200g), at approximately 95°C. It has been found that the example tantalum pentoxide (Ta₂O₅) nano-structures 42 can withstand this particular etching process for more than one hour, while the example anodic porous alumina (Al₂O₃) nano-structure template 80 is etched away at a rate of about 1 micron per minute. Other selective etchants are also contemplated, dependent on the particular characteristics of the nano-structures, and other features.

After removal of nano-structure template 80, a base material may be applied on and around the base of nano-structure array 40 to define a base layer 30. As indicated in Fig. 3E, the base material may extend between nano-structures 42 of the nano-structure array. In some examples, the base material is deposited to a depth (shown as base layer height (H_{B})) that is less than preliminary nano-structure height (H_{P}) (Fig 3C). In other examples, the base material may be deposited to a depth that is at or near the preliminary nano-structure height (H_{P}). In the present example, nano-structures 42 extend (a distance corresponding to a nano-structure height (H_{S})) above base layer surface 32.

The base material may be deposited by electrochemical deposition, and may define a substantially planar base surface 32. Electrochemical deposition of the base layer may be achieved using an underlying layer as a cathode in a solution of base material, after removal of nano-structure template 80. In some examples, the underlying layer may be the layer of first oxidizable material 50 (e.g., the Ta layer).

A conductive layer of a multi-layer substrate (or a conductive layer deposited on substrate 20) also may be used as a cathode during electrochemical deposition of the base layer. Accordingly, where the first oxidizable layer 50 (e.g., the Ta layer) is not completely oxidized prior to removal of nano-structure template 80, anodization of the Ta layer may be continued after removal of the nano-structure template. This will tend to make the thickness of the grown oxide substantially uniform between nano-structures 42, and correspondingly, may tend to enhance uniformity of the electrochemical deposition of the base material forming base layer 30.

The base material may be a metal, a polymer, or some other material suitable for electrochemical deposition. Base layer 30 thus may be formed from conductors, semiconductors, dielectric materials, magnetic materials, piezoelectric materials, and other suitable materials. Some examples of base material are Ni, Ag, Au, CdSe, ZnSe and ZnS.

In some examples, caps 42a may be formed on the distal ends of nano-structures 42. The cap material may be a metal, a polymer, or some other material suitable for electrochemical deposit on the distal ends of nano-structures 42. Caps 42a thus may be formed from conductors, semiconductors, dielectric materials, magnetic materials, piezoelectric materials, and other suitable materials.

In some examples, caps 42a are deposited by electrochemical deposit, which may be achieved by using the nano-structures as a cathode in a solution that allows deposition of the cap material, before removal of nano-structure template 80. However, caps 42a also may be deposited by a directional deposition technique such as PVD, RF sputtering, etc. (before removal of the nano-structure template). In still other examples, caps 42a may be deposited by GLAD deposition (glancing angle deposition), where the angle of deposition may be 85-degrees or more relative to an axis normal to the deposit surface (after removal of the nano-structure template 80).

Although not particularly shown, nano-pores 82 may be re-shaped prior to deposit of caps 42a, thereby providing for formation of caps shaped differently than nano-structures 42. In some examples, nano-pores 82 are re-shaped by broadening unfilled sections of the nano-pores 82 (the sections of the nano-pores above the formed nano-structures 42). Such broadening may be achieved by selective etching of the nano-structure template 80. Selective etching may be accomplished by employing an etchant solution configured to etch the exposed areas of porous oxide forming the nano-structure template 80 (e.g., anodic porous alumina, Al₂O₃) at a rate that is substantially higher than the etch rate for the oxide of the first oxidizable material (e.g., anodic tantalum pentoxide (Ta₂O₅)).

The resulting nano-scale structure 10 may include a nano-structure array 40 with a selectable base layer 30. In some examples, the nano-scale structure 10 may further include an array of nano-scale caps 42a. The nano-scale caps may be spaced from the base layer, or may be distributed across the surface of the base layer. Spacing between the base layer and the caps may be controlled by controlling nano-structure height and/or base layer depth.

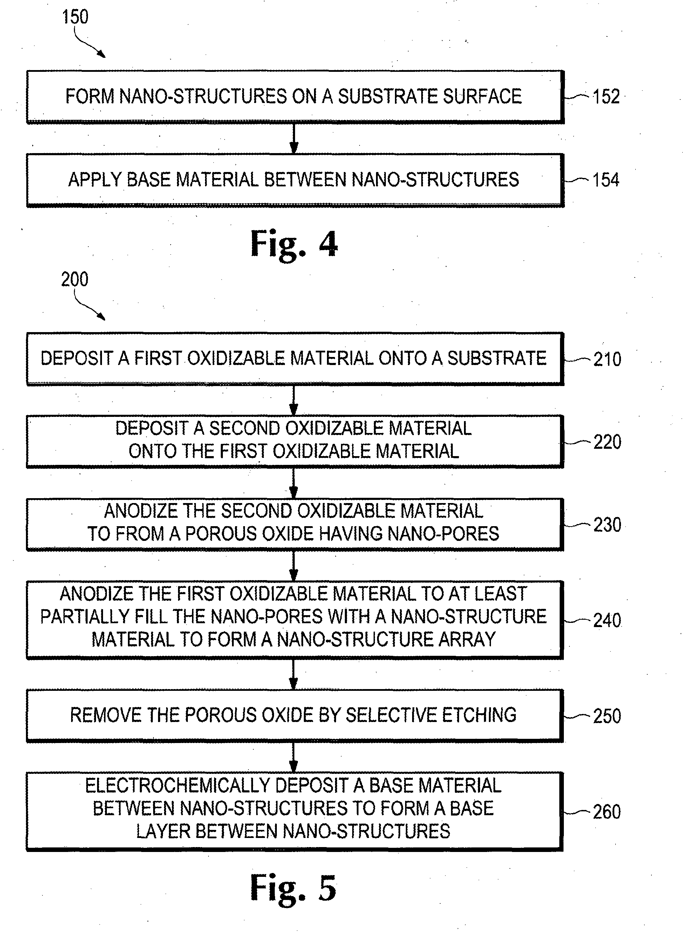

Fig. 4 shows a high-level flowchart 150 of a method of forming a nano-scale structure, as described herein. The method generally includes: (1) forming nano-structures on a substrate surface; and (2); depositing a base material between the nano-structures to form a base layer.

More particularly, at 152, nano-pillars are formed on a substrate surface. At 154, a base material is applied between the nano-structures. In some examples, the nano-pillars may be formed by applying a template to the substrate surface, at least partially filling the template with a nano-structure material to define nano-structures, and removing the template to expose the nano-structures. The nano-structures may be formed of a dense oxide.

The template may be formed using a layer of a second oxidizable material overlying a layer of a first oxidizable material. The second oxidizable material may be anodized to form a template having nano-pores. The template may overlie the first oxidizable material.

Partially filling the nano-pores may include anodizing the layer of first oxidizable material to grow oxide from the first oxidizable material into the nano-pores of the template.

The base material may be applied between the nano-structures using an underlying layer as a cathode in an electrochemical deposition process, after removal of the template. Caps also may be applied to distal ends of the nano-structures using the grown oxide as a cathode in an electrochemical deposition process, before removal of the template.

Fig. 5 shows a flowchart 200 of a method of forming a nano-scale structure, as described herein. The method generally includes: (1) depositing a first oxidizable material onto a substrate; (2) depositing a second oxidizable material onto the first oxidizable material; and (3) anodizing the second oxidizable material to form a porous oxide having nano-pores that extend through the porous oxide to expose portions of the first oxidizable material; (4) anodizing the first oxidizable material so as to at least partially fill the nano-pores in the porous oxide with a nano-structure material including an oxide of the first oxidizable material, thereby forming a nano-structure array; (5) removing the porous oxide by selective etching; (6) electrochemically depositing a base material between the nano-structures so as to form a base layer between the nano-structures.

More particularly, at 210, a first oxidizable material (which may take the form of Tantalum (Ta)) is deposited onto a substrate. At 220, a second oxidizable material is deposited onto the first oxidizable material. At 230, the second oxidizable material is anodized to form a porous oxide having nano-pores. At 240 the first oxidizable material is anodized so as to at least partially fill the nano-pores in the porous oxide with an oxide of the first oxidizable material, thereby forming a nano-structure array. At 250, the porous oxide is removed by selective etching, thereby yielding a nano-structure array. At 260, a base material is electrochemically deposited between the nano-structures so as form a base layer between the nano-structures.

In some examples, caps may be formed on the distal ends of the nano-structures. The caps also may be deposited by electrochemical deposit, before removal of nano-structure template. Furthermore, the nano-pores may be re-shaped prior to deposit of the caps, thereby providing for formation of caps shaped differently than nano-structures

Although the present invention has been described with reference to certain representative examples, various modifications may be made to these representative examples without departing from the scope of the appended claims.

## Claims

1. A method of forming a nano-scale structure, the method comprising:
depositing a first oxidizable material (50) onto a substrate surface (20);
depositing a second oxidizable material (60) onto the first oxidizable material (50);
anodizing the second oxidizable material (60) to form a porous oxide having nano-pores (82) that extend through the porous oxide to expose portions of the first oxidizable material (50);
anodizing the first oxidizable material (50) so as to partially fill the nano-pores (82) in the porous oxide with a nano-structure material including an oxide of the first oxidizable material (50), thereby forming an array of nano-structures (42) of substantially uniform height on the substrate surface (20);
removing porous oxide by selective etching, thereby yielding a substantially planar array of nano-structures (42) on the substrate surface (20); and
electrochemically depositing a base material (30) between the nano-structures (42).

2. The method of claim 1, wherein depositing the base material (30) includes depositing the base material (30) between the nano-structures (42) to define a base layer with a substantially planar base layer surface (32).

3. The method of claim 2, wherein the nano-structures (42) have a preliminary nano-structure height (Hp), and wherein depositing the base material (30) includes depositing the base material (30) to a depth is less than the preliminary nano-structure height (Hp).

4. The method of claim 1, which further comprises depositing a cap material on the nano-structures to define caps (42a) on distal ends of the nano-structures (42).

5. The method of claim 4, wherein depositing the base material (30) includes depositing the base material to a depth defining a base layer surface (32) spaced from the caps (42a).

6. The method of claim 1, wherein the nano-structures (42) are formed of tantalum pentoxide (Ta₂O₅).

7. The method of claim 1, wherein electrochemically depositing the base material (30) between the nano-structures (42) includes using a conductive layer underlying the nano-structures (42) as a cathode.

8. A nano-scale structure (10) formed according to the method of claim 1, comprising:
a substrate (20);
a nano-structure array formed on the substrate, the nano-structure array including a plurality of nano-structures (42) having distal ends;
a base layer (30) formed between the nano-structures (42); and
caps (42a) formed on the distal ends of the nano-structures (42).

9. The nano-scale structure (10) of claim 8, wherein the base layer (30) defines a substantially planar base surface (32), and wherein the caps (42a) are spaced from the substrate surface.

## Patentansprüche

1. Verfahren zum Bilden einer nanoskaligen Struktur, wobei das Verfahren Folgendes umfasst:
Abscheiden eines ersten oxidierbaren Materials (50) auf eine Substratoberfläche (20);
Abscheiden eines zweiten oxidierbaren Materials (60) auf das erste oxidierbare Material (50);
Anodisieren des zweiten oxidierbaren Materials (60), um ein poröses Oxid mit Nanoporen (82) zu bilden, die sich durch das poröse Oxid erstrecken, um Teile des ersten oxidierbaren Materials (50) freizulegen;
Anodisieren des ersten oxidierbaren Materials (50), um die Nanoporen (82) in dem porösen Oxid zum Teil mit einem Nanostrukturmaterial, das ein Oxid des ersten oxidierbaren Materials (50) enthält, zu füllen, wodurch eine Anordnung von Nanostrukturen (42) mit im Wesentlichen einheitlicher Höhe auf der Substratoberfläche (20) gebildet wird;
Entfernen von porösem Oxid durch selektives Ätzen, wodurch eine im Wesentlichen ebene Anordnung von Nanostrukturen (42) auf der Substratoberfläche (20) erzielt wird; und
elektrochemisches Abscheiden eines Basismaterials (30) zwischen den Nanostrukturen (42).

2. Verfahren nach Anspruch 1, wobei das Abscheiden des Basismaterials (30) das Abscheiden des Basismaterials (30) zwischen den Nanostrukturen (42) beinhaltet, um eine Basisschicht mit einer im Wesentlichen ebenen Basisschichtoberfläche (32) zu definieren.

3. Verfahren nach Anspruch 2, wobei die Nanostrukturen (42) eine vorläufige Nanostrukturhöhe (Hp) haben und wobei das Abscheiden des Basismaterials (30) das Abscheiden des Basismaterials (30) bis zu einer Tiefe beinhaltet, die kleiner als die vorläufige Nanostrukturhöhe (Hp) ist.

4. Verfahren nach Anspruch 1, das weiterhin das Abscheiden eines Kappenmaterials auf den Nanostrukturen beinhaltet, um Kappen (42a) an distalen Enden der Nanostrukturen (42) zu definieren.

5. Verfahren nach Anspruch 4, wobei das Abscheiden des Basismaterials (30) das Abscheiden des Basismaterials bis zu einer Tiefe beinhaltet, die eine Basisschichtoberfläche (32) definiert, die von den Kappen (42a) beabstandet ist.

6. Verfahren nach Anspruch 1, wobei die Nanostrukturen (42) aus Tantal(V)-oxid (Ta₂O₅) gebildet werden.

7. Verfahren nach Anspruch 1, wobei das elektrochemische Abscheiden des Basismaterials (30) zwischen den Nanostrukturen (42) das Verwenden einer leitfähigen Schicht beinhaltet, die unter den Nanostrukturen (42) als eine Kathode liegt.

8. Nanoskalige Struktur (10), die gemäß dem Verfahren nach Anspruch 1 gebildet wurde, wobei die Struktur Folgendes umfasst:
ein Substrat (20);
eine Nanostrukturanordnung, die auf dem Substrat ausgebildet ist, wobei die Nanostrukturanordnung mehrere Nanostrukturen (42) mit distalen Enden beinhaltet;
eine Basisschicht (30), die zwischen den Nanostrukturen (42) ausgebildet ist; und
Kappen (42a), die an den distalen Enden der Nanostrukturen (42) ausgebildet sind.

9. Nanoskalige Struktur (10) nach Anspruch 8, wobei die Basisschicht (30) eine im Wesentlichen ebene Basisoberfläche (32) definiert, und wobei die Kappen (42a) von der Substratoberfläche beabstandet sind.

## Revendications

1. Procédé de formation d'une structure à l'échelle nanométrique, le procédé comprenant :
le dépôt d'un premier matériau oxydable (50) sur une surface de substrat (20) ;
le dépôt d'un deuxième matériau oxydable (60) sur le premier matériau oxydable (50) ;
l'anodisation du deuxième matériau oxydable (60) pour former un oxyde poreux présentant des nanopores (82) qui traversent l'oxyde poreux pour exposer des parties du premier matériau oxydable (50) ;
l'anodisation du premier matériau oxydable (50) afin de remplir partiellement les nanopores (82) dans l'oxyde poreux avec un matériau nanostructuré comprenant un oxyde du premier matériau oxydable (50), formant ainsi un réseau de nanostructures (42) de hauteur sensiblement uniforme sur la surface de substrat (20) ;
le retrait d'oxyde poreux par gravure sélective, produisant ainsi un réseau sensiblement plan de nanostructures (42) sur la surface de substrat (20) ; et
le dépôt électrochimique d'un matériau de base (30) entre les nanostructures (42).

2. Procédé selon la revendication 1, dans lequel le dépôt du matériau de base (30) comprend le dépôt du matériau de base (30) entre les nanostructures (42) pour définir une couche de base présentant une surface de couche de base sensiblement plane (32).

3. Procédé selon la revendication 2, dans lequel les nanostructures (42) présentent une hauteur de nanostructure préliminaire (Hp), et dans lequel le dépôt du matériau de base (30) comprend le dépôt du matériau de base (30) à une profondeur inférieure à la hauteur de nanostructure préliminaire (Hp).

4. Procédé selon la revendication 1, qui comprend en outre le dépôt d'un matériau de capuchon sur les nanostructures pour définir des capuchons (42a) sur des extrémités distales des nanostructures (42).

5. Procédé selon la revendication 4, dans lequel le dépôt du matériau de base (30) comprend le dépôt du matériau de base à une profondeur définissant une surface de couche de base (32) espacée des capuchons (42a).

6. Procédé selon la revendication 1, dans lequel les nanostructures (42) sont constituées d'oxyde de tantale (Ta₂O₅).

7. Procédé selon la revendication 1, dans lequel le dépôt électrochimique du matériau de base (30) entre les nanostructures (42) comprend l'utilisation d'une couche conductrice sous les nanostructures (42) comme une cathode.

8. Structure à l'échelle nanométrique (10) formée conformément au procédé selon la revendication 1, comprenant :
un substrat (20) ;
un réseau de nanostructures formé sur le substrat, le réseau de nanostructures comprenant une pluralité de nanostructures (42) présentant des extrémités distales ;
une couche de base (30) formée entre les nanostructures (42) ; et
des capuchons (42a) formés sur les extrémités distales des nanostructures (42).

9. Structure à l'échelle nanométrique (10) selon la revendication 8, dans laquelle la couche de base (30) définit une surface de base sensiblement plane (32), et dans laquelle les capuchons (42a) sont espacés de la surface de substrat.
